(19) Europäisches Patentamt / European Patent Office / Office européen des brevets

(11) **EP 4 543 164 A1**

(12) **EUROPEAN PATENT APPLICATION**

(43) Date of publication:
23.04.2025 Bulletin 2025/17

(21) Application number: 24205234.8

(22) Date of filing: 08.10.2024

(51) International Patent Classification (IPC):
H10D 64/01 (2025.01)      H10D 64/68 (2025.01)
G06N 3/063 (2023.01)      H10D 30/01 (2025.01)
H10B 51/30 (2023.01)      H10D 30/68 (2025.01)

(52) Cooperative Patent Classification (CPC):
H10D 64/689; H10D 64/685; G06N 3/063;
H10B 51/30; H10D 30/0415; H10D 30/701;
H10D 64/205

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 16.10.2023 KR 20230137981

(71) Applicant: Samsung Electronics Co., Ltd
Suwon-si, Gyeonggi-do 16677 (KR)

(72) Inventors:
• YOO, Sijung
16678 Suwon-si (KR)

• NAM, Seunggeol
16678 Suwon-si (KR)
• KIM, Donghoon
16678 Suwon-si (KR)
• LEE, Hyunjae
16678 Suwon-si (KR)
• CHOE, Dukhyun
16678 Suwon-si (KR)
• CHOI, Seokhoon
16678 Suwon-si (KR)

(74) Representative: Elkington and Fife LLP
Prospect House
8 Pembroke Road
Sevenoaks, Kent TN13 1XR (GB)

(54) **FERROELECTRIC FIELD EFFECT TRANSISTOR, MEMORY DEVICE, AND NEURAL NETWORK DEVICE**

(57)     A ferroelectric field effect transistor includes a channel, a gate electrode provided to face the channel, a ferroelectric layer provided between the channel and the gate electrode, an interfacial layer provided between the channel and the ferroelectric layer, and a diffusion barrier layer provided between the ferroelectric layer and the gate electrode, wherein the diffusion barrier layer includes SiON, the diffusion barrier layer has an oxygen concentration gradient that gradually decreases from a first surface of the diffusion barrier layer facing the gate electrode toward a second surface of the diffusion barrier layer facing the ferroelectric layer, and the diffusion barrier layer may have a nitrogen concentration gradient that gradually increases from the first surface toward the second surface.

FIG. 1

EP 4 543 164 A1

**Description**

FIELD OF THE INVENTION

The disclosure relates to a ferroelectric field effect transistor, a memory device, and a neural network device.

BACKGROUND OF THE INVENTION

Ferroelectrics are materials with ferroelectricity, which means that they maintain spontaneous polarization by aligning their internal electric dipole moments even when no electric field is applied from an external electric field source. Therefore, when a predetermined voltage is applied to ferroelectrics, polarization remains semi-permanent in the ferroelectrics even when the applied voltage is returned to 0 V. Research on applying these ferroelectric properties to logic devices and/or memory devices has been conducted. For example, in the case of a ferroelectric field effect transistor using ferroelectrics, the threshold voltage of the field effect transistor may vary with the polarization direction in the ferroelectrics. Logic devices or memory devices may be implemented using threshold voltage variation characteristics of such ferroelectric field effect transistors.

SUMMARY OF THE INVENTION

Provided is a ferroelectric field effect transistor including a diffusion barrier layer for increasing a memory window, which is a difference between two different threshold voltages.
In addition, provided are a memory device and a neural network device including the diffusion barrier layer.
Additional aspects will be set forth in part in the description which follows and, in part, will be apparent from the description, or may be learned by practice of the presented embodiments of the disclosure.
According to an aspect of an embodiment, a ferroelectric field effect transistor includes a channel, a gate electrode facing the channel, a ferroelectric layer between the channel and the gate electrode, an interfacial layer between the channel and the ferroelectric layer, and a diffusion barrier layer between the ferroelectric layer and the gate electrode, wherein the diffusion barrier layer includes SiON, has an oxygen concentration gradient that decreases from a first surface of the diffusion barrier layer facing the gate electrode toward a second surface of the diffusion barrier layer facing the ferroelectric layer, and has a nitrogen concentration gradient that increases from the first surface toward the second surface.
The oxygen concentration is highest on the first surface of the diffusion barrier layer, and lowest on the second surface of the diffusion barrier layer such that the oxygen concentration on the first surface of the diffusion barrier layer may be higher at a ratio of about 10 % or more with respect to the oxygen concentration on the second surface of the diffusion barrier layer.
The nitrogen concentration is lowest on the first surface of the diffusion barrier layer, and highest on the second surface of the diffusion barrier layer such that the nitrogen concentration on the second surface of the diffusion barrier layer may be higher at a ratio of about 10 % or more with respect to the nitrogen concentration on the first surface of the diffusion barrier layer.
The diffusion barrier layer may have a silicon concentration gradient that increases from the first surface toward the second surface.
The silicon concentration is lowest on the first surface of the diffusion barrier layer, and highest on the second surface of the diffusion barrier layer such that the silicon concentration on the second surface of the diffusion barrier layer may be higher at a ratio of about 10 % or more with respect to the silicon concentration on the first surface of the diffusion barrier layer.
A ratio of a silicon concentration to the nitrogen concentration on the first surface of the diffusion barrier layer and a ratio of the silicon concentration to the nitrogen concentration on the second surface of the diffusion barrier layer may be the same.
The diffusion barrier layer may include an amorphous structure.
The ferroelectric field effect transistor may further include a tunnel barrier layer between at least one of the diffusion barrier layer and the gate electrode or the ferroelectric layer and the diffusion barrier layer.
The interfacial layer may include, for example, at least one of $SiO_2$, AlN, or $Si_3N_4$.
The interfacial layer may include, for example, SiON.
The interfacial layer may have an oxygen concentration gradient that increases from a third surface of the interfacial layer facing the ferroelectric layer toward a fourth surface of the interfacial layer facing the channel.
The interfacial layer may have a nitrogen concentration gradient and a silicon concentration gradient that decrease from the third surface toward the fourth surface.
The oxygen concentration, in the interfacial layer, may be lowest on the third surface of the interfacial layer, and highest on the fourth surface of the interfacial layer such that the oxygen concentration on the fourth surface of the interfacial layer may be higher at a ratio of about 10% or more with respect to the oxygen concentration on the third surface of the interfacial layer.

The nitrogen concentration, in the interfacial layer, may be highest on the third surface of the interfacial layer, and lowest on the fourth surface of the interfacial layer such that the nitrogen concentration on the third surface of the interfacial layer may be higher at a ratio of about 10% or more with respect to the nitrogen concentration on the fourth surface of the interfacial layer.

The silicon concentration, in the interfacial layer, may be highest on the third surface of the interfacial layer, and lowest on the fourth surface of the interfacial layer such that the silicon concentration on the third surface of the interfacial layer may be higher at a ratio of about 10 % or more with respect to the silicon concentration on the fourth surface of the interfacial layer.

A ratio of the silicon concentration to the nitrogen concentration on the third surface of the interfacial layer and a ratio of the silicon concentration to the nitrogen concentration on the fourth surface of the interfacial layer may be the same .

The interfacial layer may include an amorphous structure.

The ferroelectric layer may include a plurality of first material layers and at least one second material layer provided between two of the plurality of first material layers facing each other, and the plurality of first material layers may include a ferroelectric material, and the second material layer may include a paraelectric material.

According to another aspect of an embodiment, a memory device includes a plurality of gate electrodes and a plurality of spacers alternately arranged in a first direction, a channel spaced apart from the plurality of gate electrodes and the plurality of spacers in a second direction perpendicular to the first direction, the channel extending in the first direction; a ferroelectric layer between the channel and the plurality of gate electrodes and extending in the first direction; an interfacial layer between the ferroelectric layer and the channel and extending in the first direction; and a diffusion barrier layer between the ferroelectric layer and the plurality of gate electrodes and extending in the first direction, wherein the diffusion barrier layer may have an oxygen concentration gradient that decreases from a first surface of the diffusion barrier layer facing the plurality of gate electrode toward a second surface of the diffusion barrier layer facing the ferroelectric layer, and the diffusion barrier layer may have a nitrogen concentration gradient that increases from the first surface toward the second surface.

According to another aspect of an embodiment, a neural network device includes an array of a plurality of synapse elements arranged in two dimensions, wherein each of the plurality of synapse elements includes an access transistor and a ferroelectric field effect transistor, wherein the ferroelectric field effect transistor includes a channel, a gate electrode facing the channel, a ferroelectric layer between the channel and the gate electrode, an interfacial layer between the channel and the ferroelectric layer, and a diffusion barrier layer between the ferroelectric layer and the gate electrode, wherein the diffusion barrier layer includes SiON, the diffusion barrier layer has an oxygen concentration gradient that decreases from a first surface of the diffusion barrier layer facing the gate electrode toward a second surface of the diffusion barrier layer facing the ferroelectric layer, and the diffusion barrier layer may have a nitrogen concentration gradient that increases from the first surface toward the second surface.

BRIEF DESCRIPTION OF THE DRAWINGS

The above and other aspects, features, and advantages of certain embodiments of the disclosure will be more apparent from the following description taken in conjunction with the accompanying drawings, in which:

FIG. 1 is a cross-sectional view schematically showing a structure of a ferroelectric field effect transistor according to at least one example embodiment;
FIG. 2 is a graph showing an oxygen concentration gradient in a diffusion barrier layer of the ferroelectric field effect transistor shown in FIG. 1;
FIG. 3 is a graph showing a silicon concentration gradient and a nitrogen concentration gradient in the diffusion barrier layer of the ferroelectric field effect transistor shown in FIG. 1;
FIG. 4 is a cross-sectional view schematically showing a structure of a ferroelectric field effect transistor according to at least one example embodiment;
FIG. 5 is a cross-sectional view schematically showing a structure of a ferroelectric field effect transistor according to at least one example embodiment;
FIG. 6 is a graph showing an oxygen concentration gradient in an interfacial layer of the ferroelectric field effect transistor shown in FIG. 5;
FIG. 7 is a graph showing a nitrogen concentration gradient in the interfacial layer of the ferroelectric field effect transistor shown in FIG. 5;
FIG. 8 is a cross-sectional view schematically showing a structure of a ferroelectric field effect transistor according to at least one example embodiment;

FIG. 9 is a cross-sectional view schematically illustrating a structure of a memory cell string of a memory device, according to at least one example embodiment;

FIG. 10 is a cross-sectional view schematically illustrating a structure of a memory cell string of a memory device, according to at least one example embodiment;

FIG. 11 is a cross-sectional view schematically illustrating a structure of a memory cell string of a memory device, according to at least one example embodiment;

FIG. 12 is a diagram illustrating an equivalent circuit of a memory device according to at least one example embodiment;

FIG. 13 is a schematic circuit diagram of a neural network device according to at least one example embodiment; and

FIG. 14 is a schematic block diagram showing an example configuration of an electronic device including a neural network device.

DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. Additionally, numerical terms such as "first," "second," etc., may be used to describe and/or differentiate various components, but are used only to distinguish one component from another. The above terms are not intended to limit the difference in material or structure of the components.

Hereinafter, a ferroelectric field effect transistor, a memory device, and a neural network device will be described in detail with reference to the accompanying drawings. In the following drawings, the same reference numerals refer to the same components, and the size of each component in the drawings may be exaggerated for clarity and convenience of description. In addition, the embodiments described below are merely exemplary and various modifications are possible from these embodiments.

Hereinafter, the term "upper portion" or "on" may also include "to be present on a non-contact basis" as well as "to be in directly contact with". Additionally, it will also be understood that spatially relative terms, such as "above", "top", etc., are intended to encompass different orientations of the device in use or operation in addition to the orientation depicted in the figures, and that the device may be otherwise oriented (rotated 90 degrees or at other orientations) and the spatially relative terms used herein interpreted accordingly. The singular expression includes multiple expressions unless the context clearly implies otherwise. In addition, when a part "includes" a component, this means that it may further include other components, not excluding other components unless otherwise indicated.

The use of the term "the" and similar indicative terms may correspond to both singular and plural. If there is no explicit description of an order for steps that make up a method or vice versa, these steps can be done in an appropriate order and are not necessarily limited to the order described.

Further, the terms "unit", "module" or the like mean a unit that processes at least one function or operation, which may be implemented in processing circuitry such as hardware, software, and/or in a combination of hardware and software. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc. The processing circuitry may include electrical components such as at least one of transistors, resistors, capacitors, etc., and/or electronic circuits including said components.

The connection or connection members of lines between the components shown in the drawings exemplarily represent functional connection and/or physical or circuit connections, and may be replaceable or represented as various additional functional connections, physical connections, or circuit connections in an actual device. Additionally, when the terms "about" or "substantially" are used in this specification in connection with a numerical value and/or geometric terms, it is intended that the associated numerical value includes a manufacturing tolerance (e.g., $\pm 10\%$) around the stated numerical value. Further, regardless of whether numerical values and/or geometric terms are modified as "about" or "substantially," it will be understood that these values should be construed as including a manufacturing or operational tolerance (e.g., $\pm 10\%$) around the stated numerical value and/or geometry.

The use of all examples or exemplary terms is simply to describe technical ideas in detail, and the scope is not limited by these examples or exemplary terms unless the scope is limited by the claims.

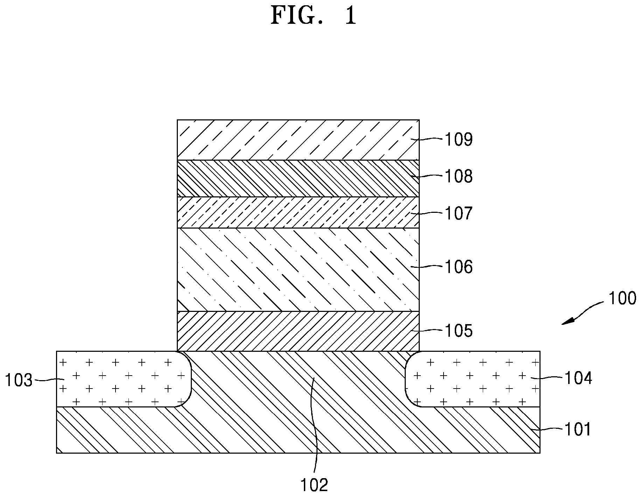

FIG. 1 is a cross-sectional view schematically showing a structure of a ferroelectric field effect transistor according to at least one example embodiment. Referring to FIG. 1, a ferroelectric field effect transistor 100 according to at least one example embodiment may include a source region 103, a drain region 104, a channel 102 provided between the source region 103 and the drain region 104, a gate electrode 109 provided facing the channel 102, a ferroelectric layer 106 provided between the channel 102 and the gate electrode 109, an interfacial layer 105 provided between the channel 102 and the ferroelectric layer 106, and a diffusion barrier layer 107 provided between the ferroelectric layer 106 and the gate electrode 109. In addition, the ferroelectric field effect transistor 100 may further include a tunnel barrier layer 108 provided between the diffusion barrier layer 107 and the gate electrode 109. In other words, the ferroelectric field effect transistor 100 may include a gate stack arranged such that the interfacial layer 105 may be provided on the upper surface of the channel 102, the ferroelectric layer 106 may be provided on the upper surface of the interfacial layer 105, the diffusion barrier layer 107 may be provided on the upper surface of the ferroelectric layer 106, the tunnel barrier layer 108 may be provided on the upper surface of the diffusion barrier layer 107, and the gate electrode 109 may be provided on the upper surface of the tunnel barrier layer 108.

The ferroelectric field effect transistor 100 may further include a substrate 101. In at least one embodiment, the source region 103 and the drain region 104 may be provided on both sides of the upper portion of the substrate 101, respectively, and/or on opposite sides of a partial region of the upper portion of the substrate 101. The channel 102 may be the partial region of the upper portion of the substrate 101. Although not shown, the ferroelectric field effect transistor 100 may further include a source electrode and a drain electrode provided above and electrically connected to the source region 103 and the drain region 104, respectively.

In at least one embodiment, the source region 103 and the drain region 104 may be doped with a first conductance type at a first concentration, and the substrate 101 may be doped with a second conductance type electrically opposed to the first conductance type at a second concentration. For example, the substrate 101 may include a p-type semiconductor, the source region 103 and the drain region 104 may include an n-type semiconductor, or the substrate 101 may include an n-type semiconductor, and the source region 103 and the drain region 104 may include a p-type semiconductor. The substrate 101 may be doped at a relatively low concentration of about $10^{16}$ to $10^{17}$ cm$^{-3}$, while the source region 103 and the drain region 104 may be doped at a relatively high concentration of about $10^{19}$ to $10^{21}$ cm$^{-3}$ for low resistance. The source region 103 and the drain region 104 may be formed by doping a portion of the upper portion of the substrate 101, respectively. The upper region of the substrate 101 between the source region 103 and the drain region 104 becomes the channel 102. Accordingly, the channel 102 may be provided between the source region 103 and the drain region 104 in the upper region of the substrate 101. However, this is only an example, and the embodiments are not limited thereto. For example, in at least one embodiment, at least one of the channel 102, the source region 103, and/or the drain region 104 may be deposited and/or transferred onto the substrate 101.

As such, the substrate 101, the channel 102, the source region 103, and the drain region 104 may include, as a base material, at least one semiconductor material among, for example, group IV semiconductors (such as silicon (Si), germanium (Ge), and SiGe), group III-V compound semiconductors (such as GaAs and GaP), group II-VI compound semiconductors, oxide semiconductors, two-dimensional material semiconductors, and/or the like. When the substrate 101, the channel 102, the source region 103, and the drain region 104 include Si, Ge, SiGe, etc., the substrate 101 and the channel 102 may be doped with at least one dopant of, e.g., B, Al, Ga, and In, and the source region 103 and the drain region 104 may be doped with at least one dopant of, e.g., P, As, and Sb. Then, the ferroelectric field effect transistor 100 becomes an n-channel metal oxide semiconductor (NMOS) field effect transistor. Alternatively, the substrate 101 and the channel 102 may be doped with at least one dopant of, e.g., P, As, and Sb, and the source region 142 and the drain region 143 may be doped with at least one dopant of, e.g., B, Al, Ga, and In. In this case, the ferroelectric field effect transistor 100 becomes a p-channel metal oxide semiconductor (PMOS) field effect transistor.

The ferroelectric layer 106 may include a ferroelectric material. Ferroelectrics are materials with ferroelectricity that maintain spontaneous polarization by aligning internal electric dipole moments without an electric field being applied from an external electric field source. The threshold voltage of the ferroelectric field effect transistor 100 may change depending on a polarization direction of the ferroelectric layer 106, for example, a direction from the gate electrode 109 to the channel 102, or vice versa. In at least one embodiment, the ferroelectric material may be (or include) a material having a non-centrosymmetric (NCS) material phase.

The ferroelectric layer 106 may include, for example, a ferroelectric having at least one of a fluorite structure, a perovskite structure, and a wurtzite structure. The ferroelectric having a fluoride structure may include, for example, hafnium oxide ($HfO_2$). For example, the hafnium oxide may be doped with at least one element of zirconium (Zr), lanthanum (La), aluminum (Al), silicon (Si), yttrium (Y), gadolinium (Gd), and/or the like; and/or the ferroelectric layer 106 may include hafnium and zirconium in substantially the same element ratio (e.g., $Hf_{0.5}Zr_{0.5}O_2$), and additionally, at least one element among lanthanum (La), aluminum (Al), silicon (Si), yttrium (Y), gadolinium (Gd), and/or the like may be doped at a ratio of less than about 10 atomic percent (at%). In addition, the ferroelectric having a perovskite structure may include, for example, lead zirconate titanate (PZT). The ferroelectric having a wurtzite structure may include, for example, zinc oxide (ZnO), aluminum nitride (AlN), and/or the like. The ferroelectric of such a wurtzite structure may be doped with, for example, at least one element of boron (B), scandium (Sc), and/or the like. The thickness of the ferroelectric layer 106 may be, for example, about 5 nanometers (nm) to about 20 nm.

In at least one embodiment, the ferroelectric layer 106 may further include an antiferroelectric material. For example, the antiferroelectric material may include zirconium oxide. For example, the zirconium oxide may be doped with at least one element of hafnium (Hf), lanthanum (La), aluminum (Al), silicon (Si), yttrium (Y), gadolinium (Gd), and/or the like.

The gate electrode 109 may have conductance of approximately 1 Mohm/square or less. The gate electrode 109 may include one or more metals, metal nitrides, metal carbides, polysilicon, and/or combinations thereof. For example, the metals may include aluminum (Al), tungsten (W), molybdenum (Mo), titanium (Ti), tantalum (Ta), and/or the like, the metal nitrides may include titanium nitride (TiN), tantalum nitride (TaN), and/or the like, and the metal carbides may include aluminum or silicon doped (or containing) metal carbides, for example, TiAlC, TaAlC, TiSiC TaSiC, and/or the like.

In at least one embodiment, the gate electrode 109 may have a structure in which a plurality of materials are stacked. For example, the gate electrode 109 may have a laminated structure of a metal nitride layer/metal layer such as TiN/Al and/or a laminated structure of a metal nitride layer/metal carbide layer/metal layer such as TiN/TiAlC/W. The gate electrode 109 may include a titanium nitride (TiN) layer or molybdenum (Mo), and the example may be used in various modifications.

In addition, the gate electrode 109 may include a conductive two-dimensional material in addition to and/or as alternative to the materials described above. For example, the conductive two-dimensional material may include at least one of graphene, black phosphorus, amorphous boron nitride, two-dimensional hexagonal boron nitride (h-BN), phosphorene, and/or the like.

The interfacial layer 105 may be formed by naturally oxidizing the semiconductor material of the channel 102 in the process of manufacturing the ferroelectric field effect transistor 100. Thus, in these examples, the interfacial layer 105 may include an oxide of a semiconductor material. For example, when the channel 102 includes Si, Ge, SiGe, etc., the interfacial layer 105 may include $SiO_2$, $GeO_2$, $SiGeO_4$, etc. The thickness of the interfacial layer 105 may be about 0.1 nm to 5 nm, and/or about 0.1 nm to about 2 nm.

When oxygen passing through the ferroelectric layer 106 and penetrating into the interfacial layer 105 is increased in the process of manufacturing the ferroelectric field effect transistor 100, the thickness of the interfacial layer 105 may be excessively increased. In addition, the layer quality of the interfacial layer 105 may be deteriorated, thereby increasing defects in the interfacial layer 105. For this reason, a memory window, which represents a difference between two different threshold voltages of the ferroelectric field effect transistor 100, may be reduced.

The memory window MW of the ferroelectric field effect transistor 100 may be represented by Equation 1 below.

[Equation 1]

$$MW = \frac{\Delta P - \Delta Q_{it}}{C_{FE}} + \frac{\Delta Q'_{it} - \Delta Q_{it}}{C_{TD}}$$

In Equation 1 above, $\Delta P$ is the polarization amount of the ferroelectric layer 106, $\Delta Q_{it}$ is the amount of charge trapped at the interface of the ferroelectric layer 106 facing the channel 102, $\Delta Q'_{it}$ is the amount of charge trapped at the interface of the ferroelectric layer 106 facing the gate electrode 109, $C_{FE}$ is the capacitance of the ferroelectric layer 106, and $C_{TD}$ is the capacitance of the layers between the ferroelectric layer 106 and the gate electrode 109. In other words, $\Delta Q_{it}$ is the amount of charge trapped at the interface between the ferroelectric layer 106 and the interfacial layer 105.

When the thickness of the interfacial layer 105 increases and the defects in the interfacial layer 105 increase, $\Delta Q_{it}$ may increase. As may be seen from Equation 1, as $\Delta Q_{it}$ increases, the memory window of the ferroelectric field effect transistor 100 decreases, so that the performance of the ferroelectric field effect transistor 100 may deteriorate.

The diffusion barrier layer 107 may prevent and/or minimize an increase in the thickness of the interfacial layer 105 and deterioration of the layer quality by preventing and/or reducing oxygen from passing through the gate electrode 109 and the ferroelectric layer 106 and penetrating into the interfacial layer 105 in the process of manufacturing the ferroelectric field effect transistor 100. The thickness of the diffusion barrier layer 107 may have a thickness of about 1 nm or more to prevent penetration of oxygen. In addition, the thickness of the diffusion barrier layer 107 may be about 5 nm or less, and/or about 3 nm or less, so that the distance between the ferroelectric layer 106 and the gate electrode 109 does not become too great.

Further, when the diffusion barrier layer 107 is additionally present between the gate electrode 109 and the ferroelectric layer 106, the capacitance $C_{TD}$ of the layers between the gate electrode 109 and the ferroelectric layer 106 may be reduced. As may be seen from Equation 1, when the capacitance $C_{TD}$ of the layers between the gate electrode 109 and the ferroelectric layer 106 decreases, the memory window may increase. In addition, the diffusion barrier layer 107 may further increase the memory window by increasing the amount of charge $Q'_{it}$ trapped at the interface of the ferroelectric layer 106 facing the gate electrode 109.

To prevent or reduce the penetration of oxygen, the diffusion barrier layer 107 may include a material having a relatively low oxygen permeability. In addition, the diffusion barrier layer 107 may include a material having a relatively low dielectric constant to lower the capacitance $C_{TD}$. For example, the diffusion barrier layer 107 may include silicon oxynitride (SiON) having an amorphous structure. When the diffusion barrier layer 107 has an amorphous structure, permeation of other materials may be effectively suppressed. In addition, the concentration of oxygen elements in the diffusion barrier layer 107 may increase toward the gate electrode 109 due to the capture of oxygen in the process of manufacturing the ferroelectric field effect transistor 100 and/or intentionally in order to prevent penetration of oxygen. Accordingly, a concentration gradient of the oxygen elements may appear in the diffusion barrier layer 107.

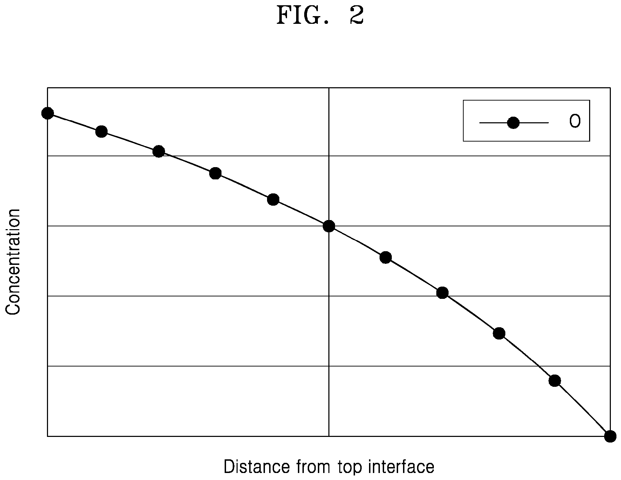

FIG. 2 is a graph showing an oxygen concentration gradient in the diffusion barrier layer 107 of the ferroelectric field effect transistor 100 shown in FIG. 1. In the graph of FIG. 2, the horizontal axis is the unitless distance from the upper surface (or first surface) of the diffusion barrier layer 107 facing the gate electrode 109 to the lower surface (or second surface) of the diffusion barrier layer 107 facing the ferroelectric layer 106, and the vertical axis is the unitless concentration of oxygen elements in the diffusion barrier layer 107. As shown in FIG. 2, the diffusion barrier layer 107 may have an oxygen concentration gradient that gradually decreases from an upper surface toward a lower surface. In other words, the oxygen concentration may be the highest on the upper surface of the diffusion barrier layer 107, and the oxygen concentration may be the lowest on the lower surface of the diffusion barrier layer 107 due to the gradual decrease in the oxygen concentration toward the lower surface of the diffusion barrier layer 107.

For example, compared to the oxygen concentration on the lower surface of the diffusion layer 107, the oxygen concentration on the upper surface of the diffusion layer 107 may be higher at a rate of about 10% or more, about 50% or more, about 100% or more, and/or about 300% or more. In other words, a ratio of the oxygen concentration on the upper surface of the diffusion layer 107 to the oxygen concentration on the lower surface of the diffusion layer 107 may be about 1.1 or more, about 1.5 or more, about 2 or more, or about 4 or more. For example, the difference between the oxygen concentration on the upper surface of the diffusion barrier layer 107 and the oxygen concentration on the lower surface of the diffusion barrier layer 107 (the oxygen concentration on the upper surface of the diffusion barrier layer 107 - the oxygen concentration on the lower surface of the diffusion barrier layer 107) may be about 5 at% or more, about 10 at% or more, and/or about 20 at% or more. If the oxygen concentration difference between the upper surface and the lower surface of the diffusion barrier layer 107 is about 5 at% or more, the maximum oxygen concentration difference between the upper surface and the lower surface of the diffusion barrier layer 107 need not be limited because the diffusion barrier layer 107 may sufficiently prevent or reduce the penetration of oxygen into the interfacial layer 105. However, considering the amount of oxygen that may be coupled to the diffusion barrier layer 107, the difference between the oxygen concentration on the upper surface of the diffusion barrier layer 107 and the oxygen concentration on the lower surface of the diffusion barrier layer 107 may be less than or equal to about 60 at%.

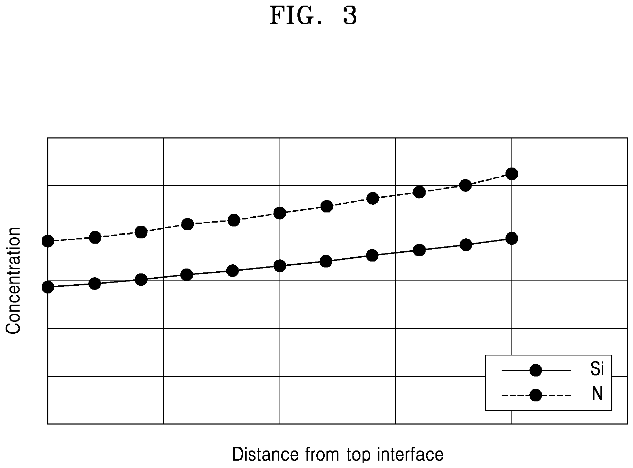

In addition, the concentration of the silicon (Si) element and the concentration of the nitrogen (N) element may change according to the change in the concentration of the oxygen element in the diffusion barrier layer 107. FIG. 3 is a graph showing a silicon concentration gradient and a nitrogen concentration gradient in the diffusion barrier layer 107 of the ferroelectric field effect transistor 100 shown in FIG. 1. Referring to FIG. 3, the diffusion barrier layer 107 may have a silicon concentration gradient and a nitrogen concentration gradient that gradually increase from an upper surface toward a lower surface. In other words, the silicon concentration is the lowest on the upper surface of the diffusion barrier layer 107, and the silicon concentration gradually increases toward the lower surface of the diffusion barrier layer 107, so that the silicon concentration may be maximum on the lower surface of the diffusion barrier layer 107. Likewise, the nitrogen concentration is the lowest on the upper surface of the diffusion barrier layer 107, and the nitrogen concentration gradually increases toward the lower surface of the diffusion barrier layer 107, so that the nitrogen concentration may be maximum on the lower surface of the diffusion barrier layer 107. Therefore, in at least some embodiments, the concentration of oxygen may be referred to as being in an inverse relationship to the concentration of the silicon and/or the nitrogen in the diffusion barrier layer 107.

For example, the silicon concentration on the lower surface of the diffusion layer 107 may be higher at a rate of about 10% or more, about 20% or more, about 50% or more, and/or about 100% or more, compared to the silicon concentration on the upper surface of the diffusion layer 107. The difference between the silicon concentration on the lower surface of the diffusion barrier layer 107 and the silicon concentration on the upper surface of the diffusion barrier layer 107 may be about 5 at% or more, about 10 at% or more, and/or about 20 at% or more, and less than or equal to about 60 at%. In addition, compared to the nitrogen concentration on the upper surface of the diffusion layer 107, the nitrogen concentration on the lower surface of the diffusion layer 107 may be higher at a rate of about 10% or more, about 20% or more, about 50% or more, or about 100% or more. The difference between the nitrogen concentration on the lower surface of the diffusion barrier layer 107 and the nitrogen concentration on the upper surface of the diffusion barrier layer 107 may be about 5 at% or more, about 10 at% or more, or about 20 at% or less, and less than or equal to about 60 at%.

Meanwhile, a ratio of the silicon concentration to the nitrogen concentration in the diffusion barrier layer 107 may be constant. In other words, the ratio of the silicon concentration to the nitrogen concentration may not change within all regions of the diffusion barrier layer 107. For example, the ratio of the silicon concentration to the nitrogen concentration on the lower surface of the diffusion barrier layer 107 and the ratio of the silicon concentration to the nitrogen concentration on the upper surface of the diffusion barrier layer 107 may be same with each other. Here, the term "the same" does not mean "the perfectly consistent", and if the deviation of the ratio of the silicon concentration to the nitrogen concentration on the upper and lower surfaces of the diffusion barrier layer 107 is within about 5 %, the ratio of the silicon concentration to the nitrogen concentration on the lower surface of the diffusion barrier layer 107 and the ratio of the silicon concentration to the nitrogen concentration on the upper surface of the diffusion barrier layer 107 may be considered same with each other.

According to the concentration gradients of the elements described above, the dielectric constant of the diffusion barrier layer 107 decreases due to the high oxygen concentration from the ferroelectric layer 106 toward the upper surface of the diffusion barrier layer 107, and thus, the capacitance may decrease. In addition, the charge trap may increase due to the high nitrogen concentration toward the lower surface of the diffusion barrier layer 107 close to the ferroelectric layer 106. Accordingly, a charge trap may be additionally formed near the interface with the ferroelectric layer 106, and a memory window may be further increased. In addition, oxygen and nitrogen may excessively exist in stoichiometry compared to silicon in the diffusion barrier layer 107. Then, defects such as oxygen vacancies and/or nitrogen vacancies may hardly exist inside the diffusion barrier layer 107.

Referring back to FIG. 1, the tunnel barrier layer 108 provided between the diffusion barrier layer 107 and the gate electrode 109 may transfer electric charges from the gate electrode 109 to the ferroelectric layer 106 through the tunnel effect when a sufficiently high voltage (for example, a write voltage or an erase voltage) is applied to the gate electrode 109. In addition, when no voltage is applied to the gate electrode 109 and/or a low voltage (for example, a standby voltage or a read voltage) is applied to the gate electrode 109, the tunnel barrier layer 108 may prevent charges trapped at the interface of the ferroelectric layer 106 from leaking through the gate electrode 109. The tunnel barrier layer 108 may also further increase the memory window by further reducing the capacitance $C_{TD}$ of the layers between the gate electrode 109 and the ferroelectric layer 106. The tunnel barrier layer 108 may include, for example, at least one material among $SiO_2$, $Al_2O_3$, $MgO_2$, and AlN. The thickness of the tunnel barrier layer 108 may be about 1 nm to about 5 nm or about 3 nm.

When the ferroelectric layer 106 includes HZO ($HfZrO_x$), the diffusion barrier layer 107 includes SiON having a thickness of about 4 nm and having the oxygen and nitrogen concentration gradients as described above, and the tunnel barrier layer 108 includes $SiO_2$ having a thickness of about 3 nm, the memory window of the ferroelectric field effect transistor 100 according to the embodiment may be, for example, about 6.0 V or more, about 6.5 V or more, and/or 7.0 V or more. To measure the memory window, the first threshold voltage of the ferroelectric field effect transistor 100 in a relatively low threshold voltage state may be measured, and a voltage higher than or equal to a coercive voltage may be applied to the gate electrode 109 of the ferroelectric field effect transistor 100 to switch polarization direction of the ferroelectric layer 106. Thereafter, the second threshold voltage of the ferroelectric field effect transistor 100 in a relatively high threshold voltage state may be measured, and the difference between the second threshold voltage and the first threshold voltage may be calculated. The threshold voltage of the ferroelectric field effect transistor 100 may be a voltage when the current flowing between the source region 103 and the drain region 104 is saturated while gradually increasing the gate voltage applied to the gate electrode 109. Meanwhile, the memory window of the ferroelectric field effect transistor according to a comparative example, which does not include a diffusion barrier layer and includes only the HZO ferroelectric layer and the 7 nm-thick $SiO_2$ tunnel barrier layer, may be, for example, about 1.0 V or less and/or about 1.5 V or less. Therefore, it may be seen that the memory window of the ferroelectric field effect transistor 100 is greatly increased by using the diffusion barrier layer 107.

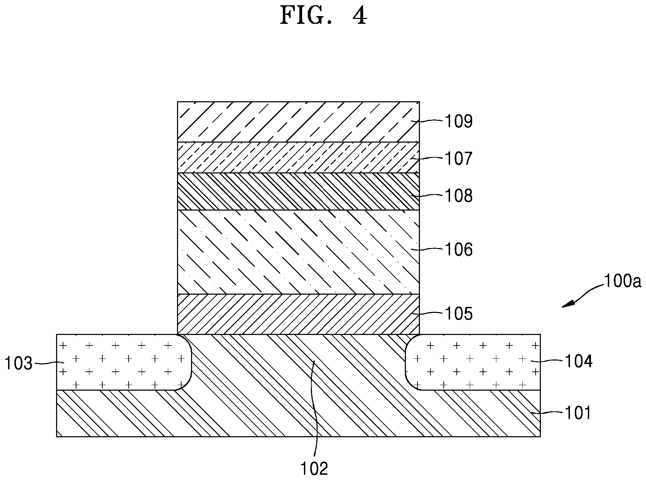

FIG. 4 is a cross-sectional view schematically showing a structure of a ferroelectric field effect transistor according to at least one example embodiment. In the ferroelectric field effect transistor 100 shown in FIG. 1, the tunnel barrier layer 108 is provided between the gate electrode 109 and the diffusion barrier layer 107, but the position of the diffusion barrier layer 107 and the position of the tunnel barrier layer 108 may be interchanged. Referring to FIG. 4, the ferroelectric field effect transistor 100a may include a diffusion barrier layer 107 provided between the gate electrode 109 and the tunnel barrier layer 108. The tunnel barrier layer 108 may be provided between the ferroelectric layer 106 and the diffusion barrier layer 107. In other words, the tunnel barrier layer 108 may be provided on the upper surface of the ferroelectric layer 106, the diffusion barrier layer 107 may be provided on the tunnel barrier layer 108, and the gate electrode 109 may be provided on the upper surface of the diffusion barrier layer 107. Otherwise, the configuration of the ferroelectric field effect transistor 100a excluding the positions of the diffusion barrier layer 107 and the tunnel barrier layer 108 may be the same as (and/or substantially similar to) the configuration of the ferroelectric field effect transistor 100 shown in FIG. 1 and thus repeat descriptions thereof have been omitted.

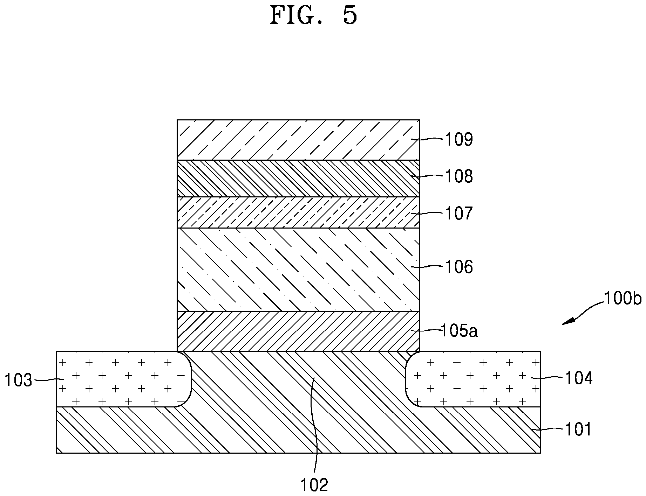

FIG. 5 is a cross-sectional view schematically showing a structure of a ferroelectric field effect transistor according to at least one example embodiment. In the ferroelectric field effect transistor 100 shown in FIG. 1, the interfacial layer 105 is described as being formed by spontaneous oxidation of the semiconductor material of the channel 102. Meanwhile, the ferroelectric field effect transistor 100b of FIG. 5 may include an interfacial layer 105a intentionally provided between the channel 102 and the ferroelectric layer 106 to prevent oxidation of the ferroelectric layer 106. In at least one embodiment, the interfacial layer 105a may include the same (and/or similar) material as the diffusion barrier layer 107. In other words, the interfacial layer 105a may include SiON having an amorphous structure. The configuration of the ferroelectric field effect transistor 100b excluding the interfacial layer 105a may be the same as that of the ferroelectric field effect transistor 100 and/or 100a shown described above.

Like the diffusion barrier layer 107, the concentration of the oxygen element in the interfacial layer 105a may increase toward the channel 102 due to the capture of oxygen in the process of manufacturing the ferroelectric field effect transistor 100b and/or intentionally to prevent the penetration of oxygen. Accordingly, a concentration gradient of the oxygen elements may appear in the interfacial layer 105a.

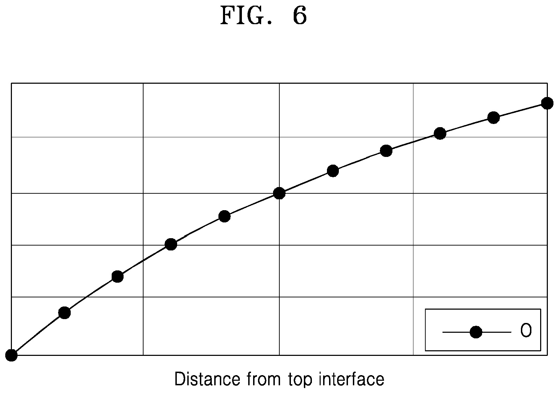

FIG. 6 is a graph showing an oxygen concentration gradient in the interfacial layer 105a of the ferroelectric field effect transistor 100b shown in FIG. 5. In the graph of FIG. 6, the horizontal axis is the unitless distance from the upper surface (or third surface) of the interfacial layer 105a facing the ferroelectric layer 106 to the lower surface (or fourth surface) of the interfacial layer 105a facing the channel 102, and the vertical axis is the unitless concentration of the oxygen element in the interfacial layer 105a. As shown in FIG. 6, the interfacial layer 105a may have an oxygen concentration gradient that gradually increases from the upper surface toward the lower surface. In other words, the oxygen concentration may be the lowest on the upper surface of the interfacial layer 105a, and the oxygen concentration may gradually increase toward the lower surface of the interfacial layer 105a, so that the oxygen concentration may be the highest on the lower surface of the interfacial layer 105a in contact with the channel 102.

For example, compared to the oxygen concentration on the upper surface of the interfacial layer 105a, the oxygen concentration on the lower surface of the interfacial layer 105a may be higher at a ratio of about 10 % or more, about 50 % or more, about 100 % or more, or about 300 % or more. The difference between the oxygen concentration on the lower surface of the interfacial layer 105a and the oxygen concentration on the upper surface of the interfacial layer 105a may be about 5 at% or more, about 10 at% or more, and/or about 20 at% or more and/or less than or equal to about 60 at%. Therefore, the oxygen concentration gradient in the interfacial layer 105a and the oxygen concentration gradient in the diffusion barrier layer 107 may be opposite to each other.

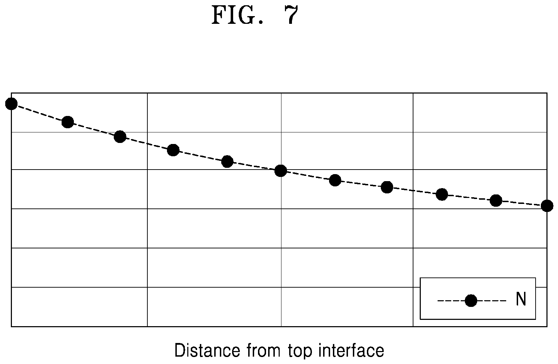

In addition, the concentration of the silicon (Si) element and the concentration of the nitrogen (N) element may change according to the change in the concentration of the oxygen element in the interfacial layer 105a. FIG. 7 is a graph showing an example of a nitrogen concentration gradient in the interfacial layer 105a of the ferroelectric field effect transistor 100b shown in FIG. 5. As shown in FIG. 7, the interfacial layer 105a may have a nitrogen concentration gradient that gradually decreases from an upper surface toward a lower surface. In other words, the nitrogen concentration is the highest on the upper surface of the interfacial layer 105a, and the nitrogen concentration gradually decreases toward the lower surface of the interfacial layer 105a, thereby minimizing the nitrogen concentration on the lower surface of the interfacial layer 105a. For example, compared to the nitrogen concentration on the lower surface of the interfacial layer 105a, the nitrogen concentration on the upper surface of the interfacial layer 105a may be higher at a rate of about 10 % or more, about 20 % or more, about 50 % or more, and/or about 100 % or more. The difference between the nitrogen concentration on the upper surface of the interfacial layer 105a and the nitrogen concentration on the lower surface of the interfacial layer 105a may be about 5 at% or more, about 10 at% or more, and/or about 20 at% or more and/or less than or equal to about 60 at%.

Although not shown in FIG. 7, a change in the silicon concentration in the interfacial layer 105a may have the same tendency as the nitrogen concentration therein. In other words, the interfacial layer 105a may have a silicon concentration gradient that gradually decreases from the upper surface toward the lower surface. For example, compared to the silicon concentration on the lower surface of the interfacial layer 105a, the silicon concentration on the upper surface of the interfacial layer 105a may be higher at a rate of about 10 % or more, about 20 % or more, about 50 % or more, and/or about 100 % or more. The difference between the silicon concentration on the upper surface of the interfacial layer 105a and the silicon concentration on the lower surface of the interfacial layer 105a may be about 5 at% or more, about 10 at% or more, or about 20 at% or more and less than or equal to about 60 at%. Therefore, the concentration gradients of nitrogen and silicon in the interfacial layer 105a and the concentration gradients of nitrogen and silicon in the diffusion barrier layer 107 may be opposite to each other.

A ratio of the silicon concentration to the nitrogen concentration in the interfacial layer 105a may be constant. In other words, the ratio of the silicon concentration to the nitrogen concentration may not change in all regions within the interfacial layer 105a. For example, the ratio of the silicon concentration to the nitrogen concentration on the lower surface of the interfacial layer 105a and the ratio of the silicon concentration to the nitrogen concentration on the upper surface of the interfacial layer 105a may be same with each other.

In at least one example embodiment, in order to reduce the trap concentration between the channel 102 and the ferroelectric layer 106 (e.g., to reduce the amount of charge $\Delta Q_{it}$ trapped at the interface of the ferroelectric layer 106 facing the channel 102) other materials other than SiON may be intentionally deposited on the channel 102 to form an interfacial layer 105a. For example, in at least one embodiment, the interfacial layer 105a may include AlN, $Si_3N_4$, or other high dielectric constant materials other than SiON. The interfacial layer 105a including AlN, $Si_3N_4$, or other high dielectric material does not prevent oxygen from penetrating from the channel 102, but may increase the memory window by reducing the trap concentration between the channel 102 and the ferroelectric layer 106. In addition, when the interfacial layer 105a has a relatively high dielectric constant, the voltage applied to the interfacial layer 105a may be lowered and the voltage applied to the ferroelectric layer 106 may be increased.

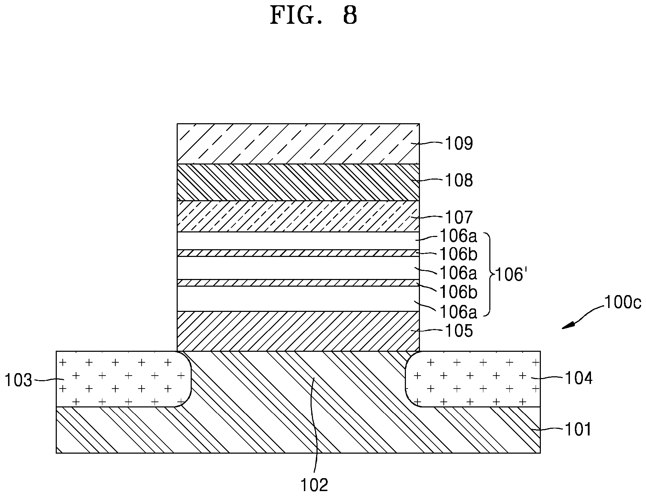

FIG. 8 is a cross-sectional view schematically showing a structure of a ferroelectric field effect transistor according to at least one example embodiment. Referring to FIG. 8, a ferroelectric layer 106' of a ferroelectric field effect transistor 100c according to at least one example embodiment may include a plurality of first material layers 106a and at least one second material layer 106b between two first material layers 106a facing each other. Although three first material layers 106a and two second material layers 106b are illustrated in FIG. 8, the numbers of the first material layers 106a and the second material layers 106b are not limited thereto. For example, the ferroelectric layer 106' may include two first material layers 106a and one second material layer 106b, or the ferroelectric layer 106' may include four first material layers 106a and three second material layers 106b. The remaining configuration of the ferroelectric field effect transistor 100c shown in FIG. 8 except for the ferroelectric layer 106' may be the same as the configuration of the ferroelectric field effect transistors 100, 100a, and/or 100b described above.

The first material layer 106a may include a ferroelectric material of the ferroelectric layer 106 described with reference to FIG. 1. For example, the first material layer 106a may include a ferroelectric having at least one of the fluorite structure, the perovskite structure, and the wurtzite structure described above. The second material layer 106b may include a paraelectric material. For example, the second material layer 106b may include at least one paraelectric of $Al_2O_3$, $SiO_2$, $La_2O_3$, and $Y_2O_3$.

In the case of the above-described ferroelectric material, when the thickness is about 10 nm or more, ferroelectric characteristics may gradually deteriorate as the thickness increases. Accordingly, it is difficult to form the ferroelectric layer 106 of FIG. 1 into a single layer having a thickness of about 20 nm or more. As shown in FIG. 8, by stacking the plurality of first material layers 106a including a ferroelectric material, the ferroelectric layer 106' may be formed to have a thickness of 20 nm or more without degrading ferroelectric properties. The thickness of each of the first material layers 106a may be, for example, about 5 nm to about 10 nm. In addition, the thickness of the second material layer 106b may be small enough not to deteriorate the ferroelectric characteristics of the ferroelectric layer 106'. For example, the thickness of the second material layer 106b may be about 0.1 nm to about 1 nm.

Until now, the ferroelectric field effect transistor having a horizontal planar channel has been described, but the diffusion barrier layer 107 described above may also be applied to a memory device having a vertical NOT-AND (VNAND) structure which is a three-dimensional (or vertical) NAND.

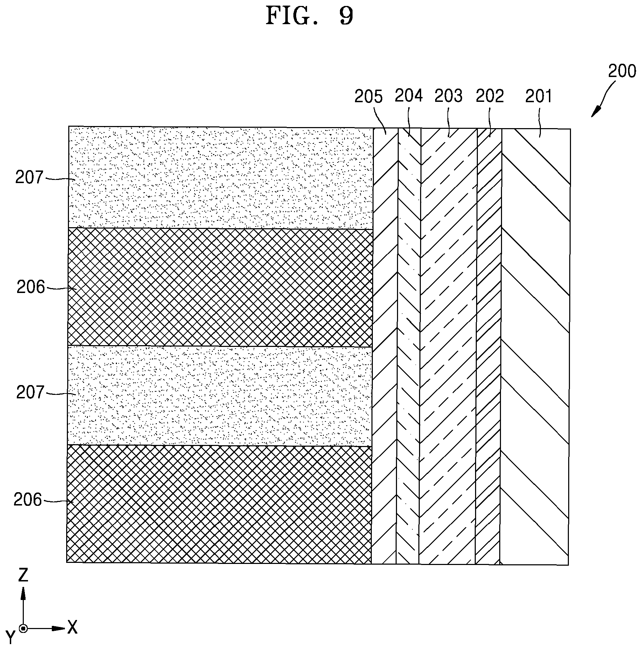

FIG. 9 is a cross-sectional view schematically illustrating a structure of a memory cell string of a memory device, according to at least one example embodiment. Referring to FIG. 9, the memory cell string 200 of the memory device according to at least one embodiment may include a plurality of gate electrodes 206 and a plurality of spacers 207, which are alternately arranged in a first direction (e.g., a Z-axis direction), a channel 201 facing and spaced apart from the plurality of gate electrodes 206 and the plurality of spacers 207 in a second direction (e.g., an X-axis direction) perpendicular to the first direction, and continuously extending in the first direction, a ferroelectric layer 203 continuously extending in the first direction and provided between the channel 201 and the plurality of gate electrodes 206, an interfacial layer 202 continuously extending in the first direction and provided between the ferroelectric layer 203 and the channel 201, and a diffusion barrier layer 204 continuously extending in the first direction and provided between the ferroelectric layer 203 and the plurality of gate electrodes 206. Furthermore, the memory cell string 200 may further include a tunnel barrier layer 205 continuously extending in the first direction and provided between the plurality of gate electrodes 206 and the diffusion barrier layer 204. For example, the tunnel barrier layer 205, the diffusion barrier layer 204, the ferroelectric layer 203, the interfacial layer 202, and the channel 201 may be sequentially provided in the second direction from the plurality of gate electrodes 206 and the plurality of spacers 207.

Each of the plurality of spacers 207 may include silicon oxide ($SiO_2$) having insulating properties, but is not limited thereto. The ferroelectric layer 203 may include the same and/or a substantially similar ferroelectric material as the ferroelectric layer 106 of FIG. 1. In addition, the interfacial layer 202 and the tunnel barrier layer 205 may be the same as and/or substantially similar to the interfacial layer 105 and the tunnel barrier layer 108 described with reference to FIG. 1.

Additionally, the diffusion barrier layer 204 may have the same characteristics as the diffusion barrier layer 107 described with reference to FIG. 1. For example, the diffusion barrier layer 204 may include SiON having an amorphous structure. In addition, the concentration gradients of oxygen, silicon, and nitrogen may appear in the diffusion barrier layer 204. For example, the oxygen concentration may gradually decrease from the first surface of the diffusion barrier layer 204 facing the plurality of gate electrodes 206 toward the second surface of the diffusion barrier layer 204 facing the ferroelectric layer 203. In other words, in at least some embodiments, the oxygen concentration may be highest on the first surface of the diffusion barrier layer 204 facing the gate electrode 206, and the oxygen concentration may be lowest on the second surface of the diffusion barrier layer 204 facing the ferroelectric layer 203. In addition, the silicon concentration and nitrogen concentration may gradually increase from the first surface of the diffusion barrier layer 204 facing the gate electrode 206 toward the second surface of the diffusion barrier layer 204 facing the ferroelectric layer 203. Therefore, the silicon and nitrogen concentrations may be the lowest on the first surface of the diffusion barrier layer 204 facing the gate electrode 206, and the silicon and nitrogen concentrations may be the highest on the second surface of the diffusion barrier layer 204 facing the ferroelectric layer 203. A ratio of the silicon concentration to the nitrogen concentration in the diffusion barrier layer 204 may be constant. Therefore, the ratio of the silicon concentration to the nitrogen concentration on the first surface of the diffusion barrier layer 204 and the ratio of the silicon concentration to the nitrogen concentration on the second surface of the diffusion barrier layer 204 may be same with each other.

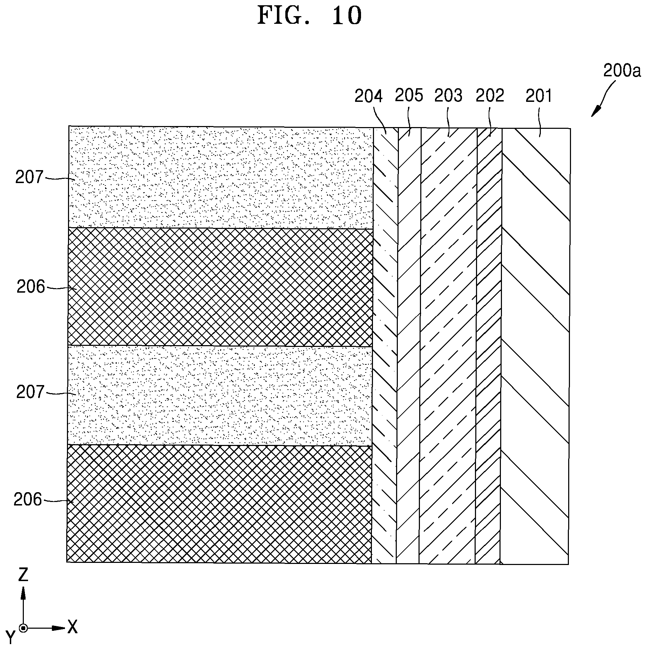

FIG. 10 is a cross-sectional view schematically illustrating a structure of a memory cell string of a memory device, according to at least one example embodiment. In the memory cell string 200 of the memory device shown in FIG. 9, the tunnel barrier layer 205 is provided between the gate electrodes 206 and the diffusion barrier layer 204, but the position of the diffusion barrier layer 204 and the position of the tunnel barrier layer 205 may be interchanged. Referring to FIG. 10, the memory cell string 200a of the memory device may include a diffusion barrier layer 204 provided between the gate electrodes 206 and the tunnel barrier layer 205. In other words, in the memory cell string 200a of the memory device, a diffusion barrier layer 204, a tunnel barrier layer 205, a ferroelectric layer 203, an interfacial layer 202, and a channel 201 may be sequentially arranged in the second direction from the plurality of gate electrodes 206 and the plurality of spacers 207. The configuration of the memory cell string 200a excluding the positions of the diffusion barrier layer 204 and the tunnel barrier layer 205 may be the same as the configuration of the memory cell string 200 shown in FIG. 9.

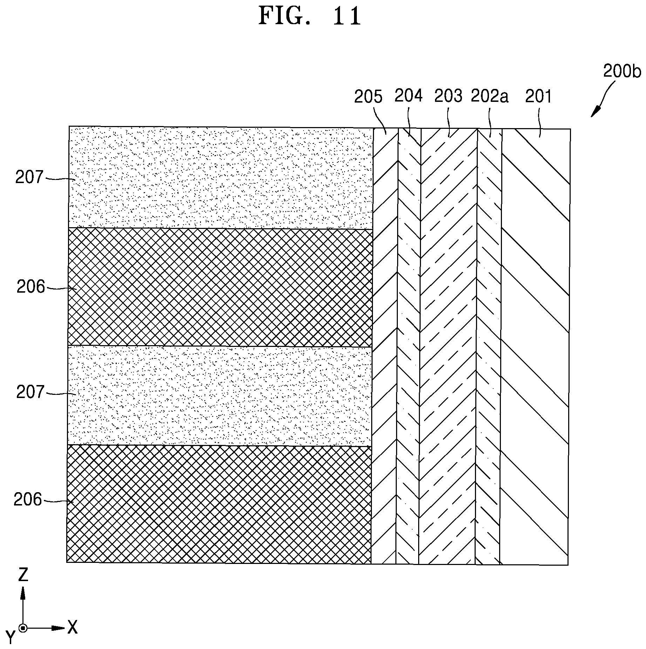

FIG. 11 is a cross-sectional view schematically illustrating a structure of a memory cell string of a memory device, according to at least one example embodiment. In the memory cell string 200 illustrated in FIG. 9, the interfacial layer 202 may be formed by naturally oxidizing a semiconductor material of the channel 201. Meanwhile, the memory cell string 200b of FIG. 11 may include an interfacial layer 202a intentionally provided between the channel 201 and the ferroelectric layer 203 to prevent oxidation of the ferroelectric layer 203. The interfacial layer 202a may include the same material as the diffusion barrier layer 204. In other words, the interfacial layer 202a may include SiON having an amorphous structure. The configuration of the memory cell string 200b except for the interfacial layer 202a may be the same as the configuration of the memory cell string 200 and/or 200a as discussed above.

The interfacial layer 202a may have the same characteristics as the interfacial layer 105a described with reference to FIG. 5. For example, the interfacial layer 202a may include SiON having an amorphous structure. In addition, the concentration gradients of oxygen, silicon, and nitrogen may appear in the interfacial layer 202a. For example, the interfacial layer 202a may have an oxygen concentration gradient that gradually increases from the third surface of the interfacial layer 202a facing the ferroelectric layer 203 toward the fourth surface of the interfacial layer 202a facing the channel 201, and may have a silicon concentration gradient and a nitrogen concentration gradient that gradually decrease from the third surface toward the fourth surface.

Therefore, the oxygen concentration may gradually increase from the third surface of the interfacial layer 202a facing the ferroelectric layer 203 toward the fourth surface of the interfacial layer 202a facing the channel 201. In other words, the oxygen concentration may be lowest on the third surface of the interfacial layer 202a, and the oxygen concentration may be highest on the fourth surface of the interfacial layer 202a. In addition, the silicon concentration and the nitrogen concentration may gradually decrease from the third surface of the interfacial layer 202a toward the fourth surface of the interfacial layer 202a. Therefore, the silicon concentration and the nitrogen concentration may be the highest on the third surface of the interfacial layer 202a, and the silicon concentration and the nitrogen concentration may be the lowest on the fourth surface of the interfacial layer 202a. A ratio of the silicon concentration to the nitrogen concentration in the interfacial layer 202a may be constant. Therefore, the ratio of the silicon concentration to the nitrogen concentration on the third surface of the interfacial layer 202a and the ratio of the silicon concentration to the nitrogen concentration on the fourth surface of the interfacial layer 202a may be same with each other.

In at least one example embodiment, in order to reduce the trap concentration between the channel 201 and the ferroelectric layer 203, materials other than SiON may be intentionally deposited between the channel 201 and the ferroelectric layer 203 to form the interfacial layer 202a. For example, the interfacial layer 202a may include AlN, $Si_3N_4$, or other high dielectric constant materials other than SiON.

In the memory cell strings 200, 200a, and 200b shown in FIGS. 9 to 11, one gate electrode 206, and the tunnel barrier layer 205, the diffusion barrier layer 204, the ferroelectric layer 203, the interfacial layer 202, and the channel 201 adjacent to the gate electrode 206 in the second direction may form one memory cell. Accordingly, it may be considered that the memory cell strings 200, 200a, and 200b include a plurality of memory cells stacked in the first direction. In addition, a memory device having a VNAND structure may include the plurality of memory cell strings 200, 200a, and 200b arranged in two dimensions.

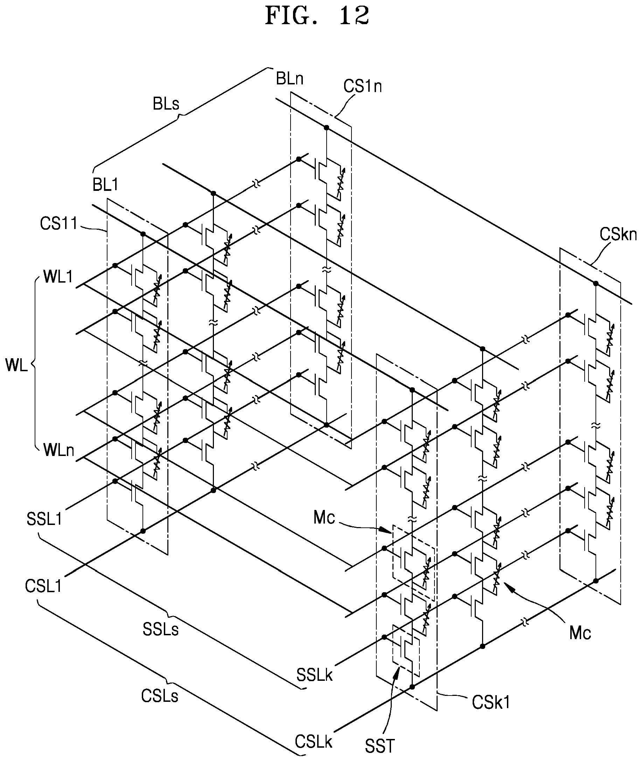

FIG. 12 is a diagram illustrating an equivalent circuit of a memory device according to at least one example embodiment. Referring to FIG. 12, the memory device may include a plurality of memory cell strings CS11 to CSkn. The plurality of memory cell strings CS11 to CSkn may be two-dimensionally arranged in a row direction and a column direction, thereby forming rows and columns. Each of the memory cell strings CS11 to CSkn may include a plurality of memory cells MC and a plurality of string selection transistors SST. The memory cells MC and the string selection transistors SST of each of the memory cell strings CS11 to CSkn may be stacked in a height direction. Each of the memory cells MC in each of the memory cell strings CS11 to CSkn may correspond to a circuit in which a transistor and a resistor are connected in parallel. For example, each of the memory cell strings CS11 to CSkn may be one of the memory cell strings 200, 200a, and 200b illustrated in FIGS. 9 to 11.

Rows of the plurality of memory cell strings CS11 to CSkn may be connected to a plurality of string selection lines SSL1 through SSLk, respectively. For example, the string selection transistors SST of the memory cell strings CS11 to CS1n may be commonly connected to the string selection line SSL1. The string selection transistors SST of the memory cell strings CSk1 to CSkn may be commonly connected to the string selection line SSLk.

In addition, columns of the plurality of memory cell strings CS11 to CSkn may be connected to the plurality of bit lines BL1 through BLn, respectively. For example, the memory cells MC and the string selection transistors SST of the memory cell strings CS11 to CSk1 may be commonly connected to the bit line BL1, and the memory cells MC and the string selection transistors SST of the memory cell strings CS1n to CSkn may be commonly connected to the bit line BLn.

In addition, the rows of the plurality of memory cell strings CS11 to CSkn may be connected to the plurality of common source lines CSL1 to CSLk, respectively. For example, the string selection transistors SST of the plurality of memory cell strings CS11 to CS1n may be commonly connected to the common source line CSL1, and the string selection transistors SST of the plurality of memory cell strings CSk1 to CSkn may be commonly connected to the common source line CSLk.

The memory cells MC located at the same height from a substrate (or the string selection transistors SST) may be commonly connected to one word line WL, and the memory cells MC located at different heights from the substrate (or the string selection transistors SST) may be connected to the plurality of word lines WL1 through WLn, respectively.

In such a structure, writing and reading may be performed in units of rows of memory cell strings CS11 to CSkn. For example, the memory cell strings CS11 to CSkn may be selected for each row by the common source lines CSL, and the memory cell strings CS11 to CSkn may be selected for each row by the string selection lines SSLs. In addition, the writing and reading operations may be performed for each page, in a selected row of the memory cell strings CS11 to CSkn. For example, the page may be one row of the memory cells MC connected to one word line WL. In the selected row of the memory cell strings CS11 to CSkn, the memory cells MC may be selected for each page by the word lines WL.

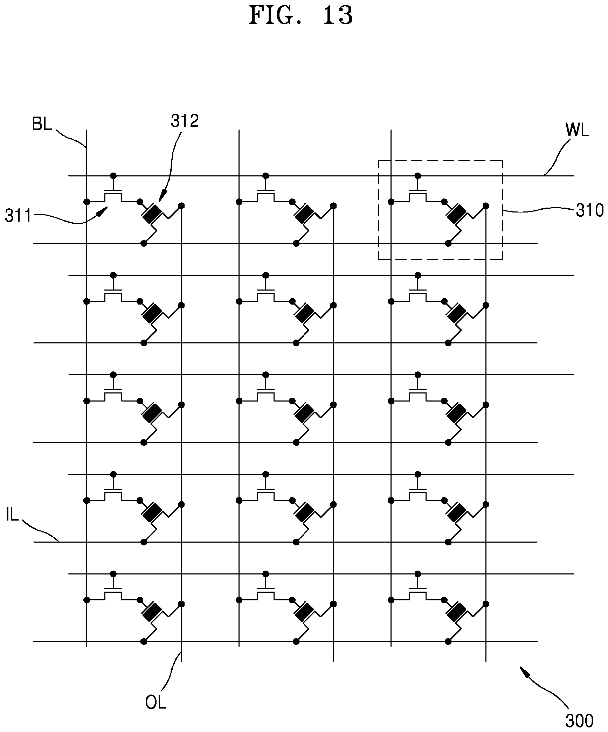

FIG. 13 is a schematic circuit diagram of a neural network device according to at least one example embodiment. Referring to FIG. 13, a neural network device 300 according to at least one example embodiment may include an array of a plurality of synapse elements 310 provided in two dimensions. Each of the plurality of synapse elements 310 may include an access transistor 311 and a ferroelectric field effect transistor 312. The ferroelectric field effect transistor 312 may be any one of the ferroelectric field effect transistors 100, 100a, 100b, and 100c described in FIGS. 1 to 8. The access transistor 311 may serve as a selection element for turning on/off the synapse element 310.

The neural network device 300 may also include a plurality of word lines WL, a plurality of bit lines BL, a plurality of input lines IL, and a plurality of output lines OL. The gate of the access transistor 311 may be electrically connected to any one of the plurality of word lines WL, the source thereof may be electrically connected to any one of the plurality of bit lines BL, and the drain thereof may be connected to the gate of the ferroelectric field effect transistor 312. Further, the source of the ferroelectric field effect transistor 312 may be electrically connected to an input line of any one of the plurality of input lines IL, and a drain thereof may be electrically connected to an output line of any one of the plurality of output lines OL.

During the learning operation of the neural network device 300, the access transistor 311 is individually turned on through individual word lines WL, and a program pulse may be applied to the gate of the ferroelectric field effect transistor 312 through the bit lines BL. A signal of the training data may be applied through the input line IL. Through this process, weights may be stored in each ferroelectric field effect transistor 312.

During the inference operation of the neural network device 300, all access transistors 311 may be turned on through the entire word lines WL, and a read voltage Vread may be applied through the bit lines BL. Then, the current from synapse elements 310 connected in parallel to the output line OL is added to and flows in each output line OL. An output circuit is connected to the plurality of output lines OL to convert a current flowing through each output line OL into a digital signal.

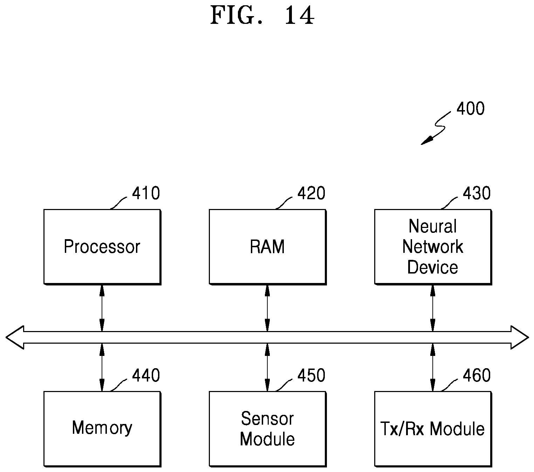

FIG. 14 is a schematic block diagram showing an example configuration of an electronic device including a neural network device. Referring to FIG. 14, the electronic device 400 may analyze input data in real time based on a neural network to extract valid information, determine a situation based on the extracted information, or control configurations of a device equipped with the electronic device 400. For example, the electronic device 400 may be applied to a robot device (such as a drone, an advanced driver assistance system (ADAS), or the like), a smart TV, a smartphone, a medical device, a mobile device, an image display device, a measurement device, and an IoT device, and/or the like, and/or may be mounted on at least one of various types of devices.

The electronic device 400 may include a processor 410, a random-access memory (RAM) 420, a neural network device 430, a memory 440, a sensor module 450, and a communication module 460. The electronic device 400 may further include an input/output module, a security module, a power control device, and the like. Some of the hardware components of the electronic device 400 may be mounted on at least one semiconductor chip.

The processor 410 controls the overall operation of the electronic device 400. The processor 410 may include one processor core or a plurality of processor cores (i.e., MultiCore). The processor 410 may process or execute programs and/or data stored in the memory 440. In some embodiments, the processor 410 may control the function of the neural network device 430 by executing programs stored in the memory 440. The processor 410 may be implemented as a central processing unit (CPU), a graphics processing unit (GPU), an application processor (AP), and/or the like.

The RAM 420 may temporarily store programs, data, or instructions. For example, programs and/or data stored in the memory 440 may be temporarily stored in the RAM 420 according to the control or boot code of the processor 410. The RAM 420 may be implemented as a memory such as dynamic RAM (DRAM), static RAM (SRAM), and/or the like.

The neural network device 430 may perform an operation of the neural network based on the received input data and generate an information signal based on the execution result. The neural network may include, but is not limited to, CNN, RNN, FNN, long short-term memory (LSTM), stacked neural network (SNN), state-space dynamic neural network (SSDNN), deep belief networks (DBN), restricted Boltzmann machine (RBM), and the like. The neural network device 430 may be a hardware accelerator itself dedicated to a neural network or a device including the same. The neural network device 430 may perform a read or write operation as well as an operation of the neural network. In at least one embodiment, neural network device 430 may correspond to the neural network device 300 according to the embodiment illustrated in FIG. 13.

The information signal may include one of various types of recognition signals such as a voice recognition signal, an object recognition signal, an image recognition signal, a biometric information recognition signal, and the like. For example, the neural network device 430 may receive frame data included in the video stream as input data and generate, from frame data, a recognition signal for an object included in an image represented by the frame data. However, the neural network device is not limited thereto, and the neural network device 430 may receive various types of input data and generate a recognition signal according to the input data according to the type or function of the device on which the electronic device 400 is mounted.

The neural network device 430 may perform, for example, machine learning model such as linear regression, logistic regression, statistical clustering, Bayesian classification, decision trees, principal component analysis, and/or expert system, and/or machine learning model of ensemble techniques, etc., such as random forest. The machine learning model may be used to provide various services such as, for example, image classification service, user authentication service based on biometric information or biometric data, advanced driver assistance system (ADAS), voice assistant service, automatic speech recognition (ASR) service, and the like.

The memory 440 is a storage place for storing data and may store an operating system (OS), various programs, and various pieces of data. In at least one example embodiment, the memory 440 may store intermediate results generated during the operation of the neural network device 430.

The memory 440 may be a DRAM, but is not limited thereto. The memory 440 may include at least one of a volatile memory and a nonvolatile memory. The nonvolatile memory includes read-only memory (ROM), programmable ROM (PROM), electrically programmable ROM (EPROM), electrically erasable and programmable ROM (EEPROM), flash memory, phase-change ROM (PROM), magnetic ROM (MROM), resistive ROM (RROM), ferroelectric ROM (FROM), and the like. The volatile memory includes dynamic RAM (DRAM), static RAM (SRAM), synchronous DRAM (SDRAM), phase-change RAM (PRAM), magnetic RAM (MRAM), resistive RAM (RRAM), and ferroelectric RAM (FeRAM). In at least one example embodiment, the memory 440 may include at least one of a hard disk drive (HDD), a solid state drive (SSD), a compact flash (CF), a secure digital (SD), a micro secure digital (Micro-SD), a mini secure digital (Mini-SD), and a memory stick. In at least one embodiment, the memory 440 may correspond to the memory device according to the embodiment illustrated in FIG. 12.

The sensor module 450 may collect information around a device on which the electronic device 400 is mounted. The sensor module 450 may sense or receive a signal (e.g., an image signal, a voice signal, a magnetic signal, a bio signal, a touch signal, etc.) from the outside of the electronic device 400 and convert the sensed or received signal into data. To this end, the sensor module 450 may include at least one of various types of sensing devices such as a sensing device, for example, a microphone, an imaging device, an image sensor, a light detection and ranging (LIDAR) sensor, an ultrasonic sensor, an infrared sensor, a biosensor, and a touch sensor.

The sensor module 450 may provide the converted data to the neural network device 430 as input data. For example, the sensor module 450 may include an image sensor, generate a video stream by photographing an external environment of the electronic device 400, and sequentially provide the continuous data frame of the video stream to the neural network device 430 as input data. However, embodiments are not limited thereto, and the sensor module 450 may provide various types of data to the neural network device 430.

The communication module 460 may include various wired or wireless interfaces and be configured to communicate with an external device. For example, the communication module 460 may include a wired local area network (LAN), a wireless local area network (WLAN) such as a wireless fidelity (Wi-Fi), a wireless personal area network (WPAN) such as Bluetooth, a wireless universal serial bus (USB), Zigbee, near field communication (NFC), radio-frequency identification (RFID), power line communication (PLC), and a communication interface capable of connecting to a mobile cellular network, such as 3rd generation (3G), 4th generation (4G), long term evolution (LTE), and/or the like.

The ferroelectric field effect transistor, the memory device, and the neural network device described above have been described with reference to the embodiments shown in the drawings.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

**Claims**

1. A ferroelectric field effect transistor comprising:

   a channel;
   a gate electrode facing the channel;
   a ferroelectric layer between the channel and the gate electrode;
   an interfacial layer between the channel and the ferroelectric layer; and
   a diffusion barrier layer between the ferroelectric layer and the gate electrode,
   wherein the diffusion barrier layer includes SiON,
   the diffusion barrier layer has an oxygen concentration gradient that decreases from a first surface of the diffusion barrier layer facing the gate electrode toward a second surface of the diffusion barrier layer facing the ferroelectric layer, and
   the diffusion barrier layer has a nitrogen concentration gradient that increases from the first surface toward the second surface.

2. The ferroelectric field effect transistor of claim 1, wherein the oxygen concentration is highest on the first surface of the diffusion barrier layer and lowest on the second surface of the diffusion barrier layer such that the oxygen concentration on the first surface of the diffusion barrier layer is higher at a ratio of 10% or more with respect to the oxygen concentration on the second surface of the diffusion barrier layer.

3. The ferroelectric field effect transistor of claim 1 or 2, wherein the nitrogen concentration is lowest on the first surface of the diffusion barrier layer and highest on the second surface of the diffusion barrier layer such that the nitrogen concentration on the second surface of the diffusion barrier layer is higher at a ratio of 10% or more with respect to the nitrogen concentration on the first surface of the diffusion barrier layer.

4. The ferroelectric field effect transistor of any preceding claim, wherein the diffusion barrier layer has a silicon concentration gradient that increases from the first surface toward the second surface, and optionally wherein the silicon concentration is lowest on the first surface of the diffusion barrier layer and highest on the second surface of the diffusion barrier layer such that the silicon concentration on the second surface of the diffusion barrier layer is higher at a ratio of 10 % or more with respect to the silicon concentration on the first surface of the diffusion barrier layer.

5. The ferroelectric field effect transistor of any preceding claim, wherein a ratio of a silicon concentration to the nitrogen concentration on the first surface of the diffusion barrier layer and a ratio of the silicon concentration to the nitrogen concentration on the second surface of the diffusion barrier layer are the same.

6. The ferroelectric field effect transistor of any preceding claim, wherein at least one of the diffusion barrier layer and the interfacial layer comprises an amorphous structure.

7. The ferroelectric field effect transistor of any preceding claim, further comprising:
   a tunnel barrier layer between at least one of the diffusion barrier layer and the gate electrode or the ferroelectric layer and the diffusion barrier layer.

8. The ferroelectric field effect transistor of any preceding claim, wherein the interfacial layer comprises at least one of $SiO_2$, AlN, or $Si_3N_4$.

9. The ferroelectric field effect transistor of any preceding claim, wherein the interfacial layer comprises SiON, and optionally wherein the interfacial layer has an oxygen concentration gradient that increases from a third surface of the interfacial layer facing the ferroelectric layer toward a fourth surface of the interfacial layer facing the channel.

10. The ferroelectric field effect transistor of claim 9, wherein the interfacial layer has a nitrogen concentration gradient and a silicon concentration gradient that decrease from the third surface toward the fourth surface, and optionally wherein, in the interfacial layer, the oxygen concentration is lowest on the third surface of the interfacial layer and highest on the fourth surface of the interfacial layer such that the oxygen concentration on the fourth surface of the interfacial layer is higher at a ratio of 10% or more with respect to the oxygen concentration on the third surface of the interfacial layer.

11. The ferroelectric field effect transistor of claim 10, wherein, in the interfacial layer, the nitrogen concentration is highest on the third surface of the interfacial layer and lowest on the fourth surface of the interfacial layer such that the nitrogen concentration on the third surface of the interfacial layer is higher at a ratio of 10% or more with respect to the nitrogen concentration on the fourth surface of the interfacial layer.

12. The ferroelectric field effect transistor of claim 10 or 11, wherein, in the interfacial layer, the silicon concentration is highest on the third surface of the interfacial layer and lowest on the fourth surface of the interfacial layer such that the silicon concentration on the third surface of the interfacial layer is higher at a ratio of 10% or more with respect to the silicon concentration on the fourth surface of the interfacial layer.

13. The ferroelectric field effect transistor of claim 10, 11 or 12, wherein a ratio of the silicon concentration to the nitrogen concentration on the third surface of the interfacial layer and a ratio of the silicon concentration to the nitrogen concentration on the fourth surface of the interfacial layer are the same.

14. The ferroelectric field effect transistor of any preceding claim, wherein

The ferroelectric layer comprises a plurality of first material layers and at least one second material layer provided between two of the plurality of first material layers facing each other, and
the plurality of first material layers comprises a ferroelectric material, and the second material layer comprises a paraelectric material.

15. A neural network device comprising:

an array of a plurality of synapse elements that are arranged two-dimensionally,
wherein each of the synapse elements includes an access transistor and a ferroelectric field effect transistor according to any preceding claim.

# FIG. 1

FIG. 2

Distance from top interface

FIG. 3

Distance from top interface

# FIG. 4

109
107
108
106
105
100a
103
104
101
102

# FIG. 5

109
108
107
106

100b

105a

103
104

101

102

FIG. 6

Distance from top interface

FIG. 7

Distance from top interface

N

FIG. 8

# FIG. 9

# FIG. 10

# FIG. 11

# FIG. 12

# FIG. 13

# FIG. 14

400

| 410 | 420 | 430 |
|---|---|---|
| Processor | RAM | Neural Network Device |

| 440 | 450 | 460 |
|---|---|---|
| Memory | Sensor Module | Tx/Rx Module |

Europäisches
Patentamt

European
Patent Office

Office européen
des brevets

# EUROPEAN SEARCH REPORT

**Application Number**

EP 24 20 5234

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/393355 A1 (YOO HYANGKEUN [KR] ET AL) 26 December 2019 (2019-12-26) | 1-6, 8-13,15 | INV. H10D64/01 |
| Y | * paragraphs [0021] - [0046], [0065] - [0069]; figures 1, 4A, 5A * ----- | 7,14 | H10D64/68 ADD. |
| Y | US 2019/304987 A1 (DONG YINGDA [US] ET AL) 3 October 2019 (2019-10-03) * paragraphs [0022] - [0024]; figure 1A * ----- | 7 | G06N3/063 H10D30/01 H10B51/30 H10D30/68 |
| Y | US 2023/298650 A1 (YAMAZAKI SHUNPEI [JP] ET AL) 21 September 2023 (2023-09-21) * paragraphs [0078] - [0080]; figures 1B3, 10A-14B * ----- | 14 | |

**TECHNICAL FIELDS SEARCHED (IPC)**

H10B
H10D

The present search report has been drawn up for all claims

| Place of search | Date of completion of the search | Examiner |
|---|---|---|
| Munich | 6 February 2025 | Alessio Verni, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 24 20 5234

This annex lists the patent family members relating to the patent documents cited in the above-mentioned European search report.
The members are as contained in the European Patent Office EDP file on
The European Patent Office is in no way liable for these particulars which are merely given for the purpose of information.

06-02-2025

| Patent document cited in search report | Publication date | Patent family member(s) | Publication date |
|---|---|---|---|
| US 2019393355 A1 | 26-12-2019 | CN 110634953 A | 31-12-2019 |
| | | KR 20200010626 A | 31-01-2020 |
| | | US 2019393355 A1 | 26-12-2019 |
| US 2019304987 A1 | 03-10-2019 | NONE | |
| US 2023298650 A1 | 21-09-2023 | CN 115867968 A | 28-03-2023 |
| | | DE 112021004116 T5 | 29-06-2023 |
| | | JP WO2022029534 A1 | 10-02-2022 |
| | | KR 20230043924 A | 31-03-2023 |
| | | US 2023298650 A1 | 21-09-2023 |
| | | WO 2022029534 A1 | 10-02-2022 |

EPO FORM P0459

For more details about this annex : see Official Journal of the European Patent Office, No. 12/82